(19) Europäisches Patentamt
European Patent Office
Office européen des brevets

(11) **EP 2 757 384 A2**

(12) **EUROPÄISCHE PATENTANMELDUNG**

(43) Veröffentlichungstag:
**23.07.2014 Patentblatt 2014/30**

(51) Int Cl.:
***G01R 31/34*** *(2006.01)*

(21) Anmeldenummer: **13198077.3**

(22) Anmeldetag: **18.12.2013**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(30) Priorität: **21.01.2013 DE 102013200872**

(71) Anmelder: **AREVA GmbH
91052 Erlangen (DE)**

(72) Erfinder: **de Beule, Catherine
90765 Fürth (DE)**

(74) Vertreter: **Kugler, Jörg
Tergau & Walkenhorst
Patentanwälte - Rechtsanwälte
Eschersheimer Landstraße 105-107
60322 Frankfurt am Main (DE)**

(54) **Verfahren und Vorrichtung zur Erkennung von Fehlern einer elektrischen Maschine**

(57)     Ein Verfahren zur Erkennung von Fehlern einer elektrischen Maschine, welcher Eingangsgrößen, Ausgangsgrößen und Maschinenparameter zugeordnet sind, soll das Erkennen der Fehler im laufenden Betrieb ermöglichen. Dazu wirddie Maschine auf ein mathematisches Modell abgebildet,wobei

• das Modell Eingangsgrößen aufweist und Modellparameter, welche jeweils Modellfunktionen von den Maschinenparametern sind,

• vor Betriebsbeginn der Maschine ein Initialabgleich der Eingangsgrößen zwischen Maschine und Modell durchgeführt wird,

• die Maschine während des Betriebs zu vorgegeben Zeitpunkten oder im Wesentlichen kontinuierlich anhand der Ausgangsgrößen überwacht wird,

• bei Abweichen der Ausgangsgrößen vom Normalfall durch einen Optimierungsprozess die Modellparameter derart bestimmt werden, dass die Ausgangsgrößen des Modells mit denen der Maschine übereinstimmen,

• und aufgrund der daraus bestimmten Modellparameter eine Fehlerdiagnose durchgeführt wird.

FIG. 1

EP 2 757 384 A2

**Beschreibung**

Die Erfindung betrifft ein Verfahren zur Erkennung von Fehlern einer elektrischen Maschine, welcher Eingangsgrößen, Ausgangsgrößen und Maschinenparameter zugeordnet sind. Sie betrifft weiterhin eine Vorrichtung zur Durchführung eines derartigen Verfahrens.

In vielen industriellen Bereichen werden Maschinen zur Erfüllung technischer Aufgaben eingesetzt. Im Bereich der elektrischen Maschinen finden neben Linearmotoren und Aktuatoren Motoren mit rotierenden Elementen, wie beispielsweise Asynchronmotoren, Anwendung. Je nach Einsatzgebiet der Maschine und Wichtigkeit des Prozesses kann eine Fehlfunktion eines elektrischen Motors fatale und kostspielige Konsequenzen haben. Aus diesen Gründen sind eine regelmäßige Beobachtung, Überwachung und Kontrolle der eingesetzten Motoren notwendig. Die internen elektrischen Größen einer elektrischen Maschine bzw. deren Änderung während des Betriebs könnten prinzipiell zur Diagnose von rotierenden Maschinen herangezogen werden. So haben Schäden in der Maschine Auswirkungen auf die Größen von z. B. Widerständen und Induktivitäten. Diese internen elektrischen Größen sind vor Inbetriebnahme der Maschine nur mit sehr großem Aufwand und während des Betriebs der Maschine gewöhnlich gar nicht messbar.

Das Erkennen von Änderungen dieser Parameter während des Betriebes wäre aber wünschenswert und würde eine Aussage über den Zustand der Maschine erlauben, so dass Alterungserscheinungen, Isolationsschäden und Überlast sowie Schäden im Innern (Windungsschlüsse, Stabbrüche) frühzeitig diagnostiziert werden könnten.

Gegenwärtig wird die Erkennung des Zustandes der Maschine aufgrund der Erfahrung der Betreiber durchgeführt, wobei geringe Abweichungen bisher meist unerkannt bleiben. Die einfachste Art der Motorenkontrolle besteht darin, die messbaren Größen des elektrischen Systems zu überwachen und im Falle einer Fehlfunktion entweder die Energiezufuhr abzuschneiden oder andere sicherheitstechnische Maßnahmen zu ergreifen in dem Fall, dass ein gemessener Wert einen zulässigen Grenzwert überschreitet. Dadurch kann zumindest verhindert werden, dass sich die Fehlfunktion des Motors schädlich auf seine Umgebung auswirkt.

Nachteilig dabei ist aber, dass der damit verbundene Abbruch des Produktionsprozesses hohe Kosten und Ausfälle verursachen kann, wenn er zu einem ungünstigen Zeitpunkt stattfindet. Beispielsweise verlangen Produktionsprozesse in der chemischen Industrie oft einen kontinuierlich ablaufenden Prozess. Ein Prozessabbruch kann zu nicht-verwertbaren Zwischenprodukten und damit zu Ausschuss führen. Bei Produktionsprozessen mit hohen geplanten Produktauslieferungszahlen können außerplanmäßige Unterbrechungen zu hohen Gewinneinbußen und damit hohen wirtschaftlichen Schäden führen.

Der Erfindung liegt die Aufgabe zugrunde, ein Verfahren zur Erkennung von Fehlern bereitzustellen, bei dem die Fehler im laufenden Betrieb erkannt werden können. Weiterhin soll eine Vorrichtung zur Ausführung dieses Verfahrens angegeben werden.

In Bezug auf das Verfahren wird die genannte Aufgabe erfindungsgemäß dadurch gelöst, dass die Maschine auf ein mathematisches Modell abgebildet wird,

wobei

- das Modell Eingangsgrößen aufweist und Modellparameter, welche Modellfunktionen von den Maschinenparametern sind,
- vor Betriebsbeginn der Maschine ein Initialabgleich der Eingangsgrößen zwischen Maschine und Modell durchgeführt wird,
- die Maschine während des Betriebs zu vorgegeben Zeitpunkten oder im Wesentlichen kontinuierlich anhand der Ausgangsgrößen überwacht wird,
- bei Abweichen der Ausgangsgrößen vom Normalfall durch einen Optimierungsprozess die Modellparameter derart bestimmt werden, dass die Ausgangsgrößen des Modells mit denen der Maschine übereinstimmen,
- und aufgrund der daraus bestimmten Modellparameter eine Fehlerdiagnose durchgeführt wird.

Vorteilhafte Ausgestaltungen der Erfindung sind Gegenstand der Unteransprüche.

Die Erfindung geht von der Überlegung aus, dass zur Vermeidung der oben angesprochenen technischen und wirtschaftlichen Nachteile Fehlfunktionen und Störungen im Betrieb identifiziert werden sollten, bevor sie zu einem Ausfall der Maschine und weiter zu Störungen der Umgebung und damit des Prozesses führen. Dies erfordert das Aufspüren auch von kleinen Abweichungen von Normalfall.

Elektrische Größen wie Widerstände und Induktivitäten, die sich bei Auftretenden von Fehlern verändern, lassen sich während des Betriebes aber gewöhnlich auf direkte Art (durch eine Messung) nicht bestimmen, so dass eine unmittelbare Fehlerdiagnose mit Hilfe dieser Werte nicht möglich ist.

Wie aber nunmehr erkannt wurde, lassen sich diese Größen indirekt bestimmen, indem während des Betriebes des Motors dieser simuliert wird, wobei die Ausgangsgrößen der simulierten Maschine Funktionen ihrer Modellparameter bzw. elektrischen Größen sind. Dies entspricht dem Fall der physikalischen Maschine, bei der auch die messbaren Ausgangsgrößen von den elektrischen Größen bzw. Maschinenparametern abhängen.

Ein Rückschluss auf die Parameter der Maschine kann erreicht werden, indem die Modellparameter variiert werden, bis die Ausgangsgrößen der simulierten Maschine mit denen der physikalischen Maschine hinreichend übereinstimmen. Diese Variation der Modellparameter lässt sich zielgerichtet durch einen Optimierungsprozess erreichen. Aufgrund der dann bestimmten Werte der Modellparameter lässt sich eine Diagnose des Maschinenzustandes durchführen, indem der veränderte Wert des Parameters einem möglichen wahrscheinlichen Schadensszenario zugeordnet werden kann.

Das erfindungsgemäße Verfahren umfasst die folgenden 4 Schritte:

- Initialabgleich zur Bestimmung der Modellparameter
- kontinuierliche oder intervallweise Überwachung der Differenz von simulierten Werten und Messwerten
- erneuter Abgleich bei Vorliegen einer relevanten Differenz
- Deutung der neuen Modellparameter im Hinblick auf den Zustand der realen bzw. physikalischen Maschine

Bevorzugt wird für wenigstens eine Modellfunktion die Einheitsfunktion gewählt. Das heißt, der jeweilige Modellparameter korrespondiert direkt zu dem entsprechenden Maschinenparameter. Dadurch kann von dem Wert eines Modellparameters direkt auf den Maschinenparameter geschlossen werden, so dass die Zuordnung zu einem konkreten Schadensszenario vereinfacht wird. Wenn für jede Modellfunktion die Einheitsfunktion gewählt wird, korrespondieren die Modellparameter direkt mit den Maschinenparametern. Alternativ dazu können auch effektive Modellparameter verwendet werden, die Funktionen von einem oder mehreren Modellparametern sind. Dies kann vorteilhaft sein bei der Parameteroptimierung. Wenn beispielsweise zwei Parameter von der Größe her ungefähr gleich groß sind, aber zu gegensätzlichen Effekten führen, kann es sinnvoll sein, aus ihnen die Summe und die Differenz zu bilden und diese beiden neuen effektiven Parameter im Optimierungsprozess zu bestimmen.

In einer bevorzugten Ausführungsform des Verfahrens ist die Maschine ein Asynchronmotor bzw. eine Asynchronmaschine mit einem Käfigläufer. Bevorzugt weist die Maschine einen Käfigläufer auf. Alternativ dazu ist die Maschine ein Schleifringmotor, welcher einen einfachen ohmschen Widerstand im Rotor aufweist, welcher im Modell zu den bereits vorhandenen hinzuaddiert werden kann. Fehlfunktionen bzw. Betriebsstörungen in Asynchronmotoren können aus unterschiedlichen Gründen auftreten. Die hauptsächlichen Gründe dafür sind:

- Überlastung bzw. Überladung
- Schäden an der Isolierung
- Phasenstörungen bzw. Schäden am Stator
- Schäden an den Lagern
- Alterungsprozesse
- Schäden am Rotor

Die Eingangsgrößen umfassen bevorzugt ein oder mehrere Elemente der Gruppe: sinusförmige Dreiphasen-Wechselspannung, Einphasen-Wechselspannung, Gleichstrom. Das Modell weist Eingangsgrößen auf, deren Werte beim Initialabgleich auf die Eingangsgrößen der elektrischen Maschine gesetzt werden können.

Die Ausgangsgrößen umfassen bevorzugt ein oder mehrere Elemente der Gruppe: Statorstrom, Statorspannung, Rotordrehzahl, elektrisches Drehmoment, mechanisches Drehmoment. Diese Größen sind auch während des Betriebes der Asynchronmaschine in einfacher und präziser Weise messbar und eignen sich daher zur Überwachung der Maschine und zur Erkennung eines von dem Normalfall abweichenden Laufverhaltens der Maschine.

In einer bevorzugten Variante des Verfahrens ist das Modell zeitabhängig und umfasst ein elektrisches Ersatzschaltbild des Asynchronmotors. Dabei werden dann die Ausgangsgrößen mit einem vorgegebenen Abtastintervall gemessen und die daraus resultierenden zeitdiskreten Funktionen numerisch gelöst. Ein Ersatzschaltbild ermöglicht eine vereinfachte Darstellung der elektrischen Größen und deren funktionellen Zusammenhänge und reduziert damit den rechnerischen Aufwand. Mathematisch-physikalische Vereinfachungen des Modells sind unproblematisch, solange Rückschlüsse auf die Maschinenparameter noch zuverlässig möglich sind.

Als Grundlage kann ein einphasiges Ersatzschaltbild dienen, welches dann durch Aufnahme von Symmetriebedingungen der Phasen zueinander und des räumlichen Aufbaus (jeweils 120° zwischen den Phasen) auf drei Phasen erweitert werden kann.

Zur Optimierung des Modells bzw. für den Optimierungsprozess, durch den die Abweichung der von dem Modell produzierten Ausgangsgrößen von den gemessenen Ausgangsgrößen der Maschine minimiert wird, können unterschiedliche Optimierungsalgorithmen verwendet werden.

In einer bevorzugten Ausführungsform des Verfahrens wird zur Optimierung ein Gradientenschrittverfahren eingesetzt. In einer besonders bevorzugten Ausführungsform wird dazu das konjugierte Gradientenschrittverfahren eingesetzt. Dieses unterscheidet sich von dem standardmäßigen Gradientenschrittverfahren im Wesentlichen in der Berechnung des Gradienten, in dem auch frühere Minimierungs- oder Maximierungsrichtungen im Parameterraum berücksichtigt werden. Die beiden Verfahren unterscheiden sich also in der Berechnung der Suchrichtung, d. h. der Richtung im multidimensionalen Parameterraum, in der ein oder mehrere Parameter im nächsten Schritt verändert werden. Der Konjugationsfaktor kann durch die Polak-Ribière Formel berechnet werden. Zur Bestimmung einer effizienten Schrittweite kann die Armijo-Regel verwendet werden.

Neben Gradientenschrittverfahren können auch - je nach Anwendungsfall - andere Optimierungsmethoden verwendet werden. Der einfachste Fall ist dabei die Gittersuche (grid search), bei der nacheinander die verschiedenen Parameter variiert werden, bis jeweils in dieser Richtung im Parameterraum der Wert der zu optimierenden Funktion näher an das Optimum gekommen ist.

Ein prinzipielles Problem der oben genannten Verfahren des steilsten Abstiegs ist, dass ihr Suchergebnis stark von den Anfangsbedingungen abhängt. Im Falle der Minimierung der Optimierungsfunktion entspricht jede neu gefundene Parameterkombination einem geringeren Wert der Minimierungsfunktion. Damit wird im Regelfall nur das nächstgelegene, lokale, Minimum gefunden. Dieses entspricht aber nicht zwangsweise dem globalen Minimum, welches der global optimalen Lösung der Parameter entspricht. Algorithmen mit einer statistischen Komponente, die die Wahrscheinlichkeit des Auffindens des globalen Minimums stark erhöhen, sind Evolutionäre Algorithmen oder auch genetische Algorithmen sowie Schwarmstrategien. Diese Algorithmen benötigen dafür aber gegebenenfalls zu lange, so dass sie nur in konkreten Anwendungsfällen eingesetzt werden können, wenn für Ihren Einsatz genug Zeit zur Verfügung steht.

Bevorzugt wird zur Optimierung die Summe von quadratischen Abweichungen der Ausgangsgrößen des Modells von denen der Maschine minimiert. Das heißt, die Summe der quadratischen Ausgangsgrößen ist die Optimierungsfunktion. Da die unterschiedlichen Ausgangsgrößen vom Betrage her unterschiedlich groß sind, kann eine unterschiedliche Gewichtung der Quadrate in der Summe sinnvoll sein. Dies kann dadurch erreicht werden, dass jeder Summand, also das Quadrat der Differenz zwischen gemessener Ausgangsgröße der Maschine und Ausgangsgröße des Modells jeweils mit einem Faktor multipliziert wird, wobei die einzelnen Faktoren zumindest teilweise unterschiedlich gewählt werden.

In Bezug auf die Vorrichtung wird die oben genannte Aufgabe erfindungsgemäß gelöst mit Mitteln zur Durchführung des oben beschriebenen Verfahrens. Diese bestehen insbesondere aus geeigneten Hard- und/oder Softwarekomponenten bzw. Modulen. Beispielsweise lässt sich das Verfahren auf einem Computer durch ein Programm implementieren, in dem das Modell implementiert ist sowie wenigstens ein Optimierungsalgorithmus. Es muss weiterhin ein Messgerät vorgesehen sein, mit deren Hilfe die Ausgangsgrößen der elektrischen Maschine regelmäßig und in vorgegebenen zeitlichen Abtastintervallen gemessen werden können. Dazu sollte auch ein Interface vorgesehen sein, durch das diese Größen an den Computer übermittelt werden. Weiterhin können dann auf einer Ausgabeeinheit, insbesondere einem Monitor, die gemessenen und die berechneten Ausgangsgrößen sowie die Modellparameter ausgegeben werden.

In einer bevorzugten Ausführungsform ist eine Datenbank vorgesehen, in der Abweichungen der Modellparameter von Normalwerten jeweils ein oder mehrere Schadensszenarien zugeordnet werden. Auf diese Weise kann ein Schaden frühzeitig identifiziert werden, und Gegenmaßnahmen können eingeleitet werden, um noch größere Schäden zu verhindern. Beispielsweise kann zu einem geeigneten Zeitpunkt die Maschine gestoppt werden und eine Komponente, bei der sich starker Verschleiß oder Materialschäden angezeigt werden, ausgetauscht werden. Dabei kann auch eine Ausgabeeinheit vorgesehen sein, auf der der wahrscheinliche Schaden und gegebenenfalls auch Vorschläge für zu ergreifende Maßnahmen angezeigt werden, z.B. auch zur Planung von Inspektion und Wartung des Motors. Die Vorteile der Erfindung liegen insbesondere darin, dass zur Bestimmung von Schadensfällen während des laufenden Betriebes einer Maschine keine aufwändigen Messvorrichtungen installiert werden müssen, vielmehr genügen die Messungen der Ausgangsgrößen zur Diagnose der Maschine. Bereits kleine Fehler mit Auswirkungen auf die elektrischen Größen der Maschine lassen sich frühzeitig detektieren. Es lassen sich auf diese Weise bei Asynchronmaschinen Änderungen der internen elektrischen Größen und damit Fehler wie Stabbruch, Isolationsschäden und Fehler aufgrund des natürlichen Alterungsprozesses zu erkennen.

Ein Ausführungsbeispiel der Erfindung wird anhand einer Zeichnung näher erläutert. Darin zeigen in stark schematisierter Darstellung:

FIG. 1      ein Ablaufdiagramm des Verfahrens in einer bevorzugten Ausführungsform,

FIG. 2      eine alternatives Diagramm zur Darstellung des Verfahrens,

FIG. 3      ein einphasiges Ersatzschaltbild einer Asynchronmaschine mit Käfigläufer,

FIG. 4      eine Stator/Rotoranordnung mit drei Statorsträngen,

FIG. 5      ein gegenüber dem Ersatzschaltbild aus FIG. 3 erweitertes Ersatzschaltbild mit dreiphasigem Aufbau,

FIG. 6      ein Ablaufdiagramm des Optimierungsprozesses, und

FIG. 7    eine Vorrichtung zur Durchführung des Verfahrens gemäß FIG.1 und FIG. 2 in einer bevorzugten Ausführungsform.

Gleiche Teile sind in allen Figuren mit denselben Bezugszeichen versehen.

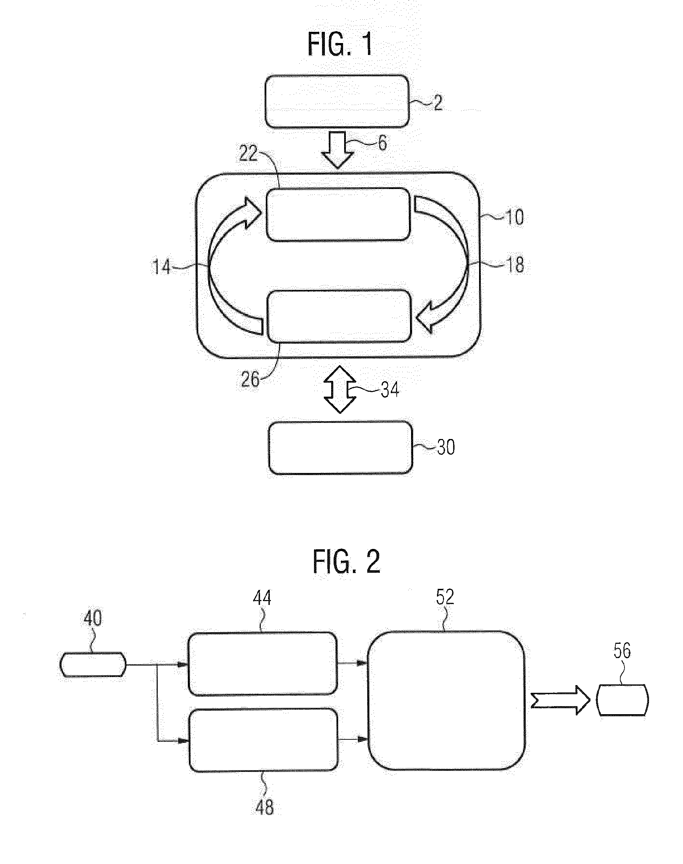

Ein in FIG. 1 gezeigtes Ablaufdiagramm des erfindungsgemäßen Verfahrens in einer bevorzugten Ausführungsform umfasst einen ersten Block 2, in dem ein Initialabgleich zwischen den Eingangsgrößen eines Asynchronmotors mit einem Käfigläufer und einem Modell durchgeführt. Für den Initialabgleich werden die durch die Herstellerunterlagen vorgegebenen Größen für Widerstände und Induktivitäten in das Modell eingegeben. Es wird davon ausgegangen, dass die Maschine in fehlerfreiem Zustand ist. Diese Größen besitzen jedoch Abweichungen von den gesuchten Modellparametern, zum einen aufgrund von Konstruktionsbedingungen (die Werte werden nicht an jeder einzelnen Maschine ermittelt, sondern für eine dedizierte Modellreihe angegeben), zum anderen sind in ihnen Skineffekte, hervorgerufen durch die magnetische Kopplung der einzelnen Stränge, und die dadurch resultierenden Verluste, nicht berücksichtigt. Daher werden die Parameter so adaptiert, dass Induktivitäten mit dem Faktor 0,6 multipliziert werden, um die für die magnetische Kopplung benötigte Blindleistung zu berücksichtigen, und Widerstände mit dem Faktor 0,85, um die Temperaturdifferenz zwischen der vom Hersteller angegebenen Maximaltemperatur und der zum Zeitpunkt des Abgleichs aktuellen Umgebungstemperatur (normale Raumtemperatur) auszugleichen. Mit dem so eingestellten Modell wird der erste Abgleich durchgeführt, sodass die Parameter in fehlerfreiem Zustand ermittelt werden können.

Das Modell umfasst ein Ersatzschaltbild für den Asynchronmotor. Die Eingangsgrößen sind alle drei Statorspannungen $U_{s1}$, $U_{s2}$ und $\underline{U}_{s3}$ als komplexe Größen mit Betrag und Phase. Dieser Initialabgleich führt dazu, dass die zeitliche Evolution des Modells mit den gleichen Anfangsbedingungen los läuft, die für die physikalische Maschine gelten.

Wie durch einen Pfeil 6 angedeutet, folgt auf den Initialabgleich der Block 10. Wie durch die beiden Pfeile 14, 18 angedeutet wird, werden innerhalb dieses Blockes die Verfahrensschritte in den Blöcken 22, 26 in einer Schleife jeweils abwechselnd hintereinander ausgeführt. In Block 22 werden die Ausgangsgrößen (Statorströme $I_{s1}$, $I_{s2}$, $I_{s3}$ als komplexe Größen mit Betrag und Phase, resultierende Drehzahl der Maschine n, an der Kupplung abgegebene Leistung der Maschine $P_{mech}$ bzw. das resultierende Drehmoment $M_{el}$) der Maschine gemessen. In Block 26 werden sie mit den durch das Modell simulierten Werten dieser Ausgangsgrößen verglichen.

Dabei wird die Differenz bzw. Abweichung der jeweils simulierten Größe von der gemessenen Größe bestimmt und überprüft, ob diese Differenz einen vorgegebenen Grenzwert bzw. Schwellenwert überschreitet. Falls diese Abweichung für nur eine Größe und/oder die Summe oder eine andere Funktion der Abweichungen nicht ein vorgegebenes Kriterien hinsichtlich eines oder mehrerer Grenzwerte erfüllt, wird wieder in Block 22 eine weitere Messung durchgeführt.

Falls die Abweichungen zu groß sind, werden die Verfahrensschritte in Block 30 durchgeführt. Dabei wird die Summe der quadratischen Abweichungen, die die Optimierungsfunktion bildet, in einem konjugierten Gradientenschrittverfahren minimiert. Da die Optimierungsfunktion eine Funktion der Modellparameter ist, ist das Resultat des Optimierungsverfahrens ein neuer Satz von Modellparametern. Dabei kann sich nur einer oder mehrere der Modellparameter geändert haben.

Die Modellparameter entsprechen im vorliegenden Ausführungsbeispiel den Maschinenparametern. Dazu gehören Stator- und Rotorwiderstände und Stator- und Rotorinduktivitäten.

Die neuen, im Optimierungsprozess gewonnen Werte der Modellparameter werden nun gedeutet im Hinblick auf den physikalischen Zustand der Maschine und Schlüsse auf ein mögliches Schadensszenario werden gezogen. Die Vorgänge in Block 30 laufen, wie durch den Doppelpfeil 34 angedeutet, bei Bedarf bzw. parallel zu den Verfahrensschritten in Block 10.

In FIG. 2 ist ein alternatives Diagramm zur Veranschaulichung des Verfahrens gemäß FIG. 1 dargestellt. In Block 40 werden die Eingangsgrößen bestimmt, welche die Anfangsbedingungen sowohl für den physikalischen Prozess in Block 44, also für den Betrieb des Asynchronmotors, als auch für das mathematische Modell in Block 48 darstellen. In Block 52 werden die gemessenen Ausgangsgrößen mit den von dem Modell vorhergesagten Ausgangsgrößen verglichen. Dieser Vergleich geschieht im vorliegenden Fall immer dann, wenn eine neue Messung der physikalischen Ausgangsgrößen stattgefunden hat und entspricht den Vorgängen in Block 10 gemäß FIG. 1. Falls eine Abweichung einen Schwellenwert überschritten hat, wird in Block 56 eine Minimierung der Optimierungsfunktion durchgeführt, was zu neuen Modellparametern führt (dies entspricht Block 30 aus FIG. 1).

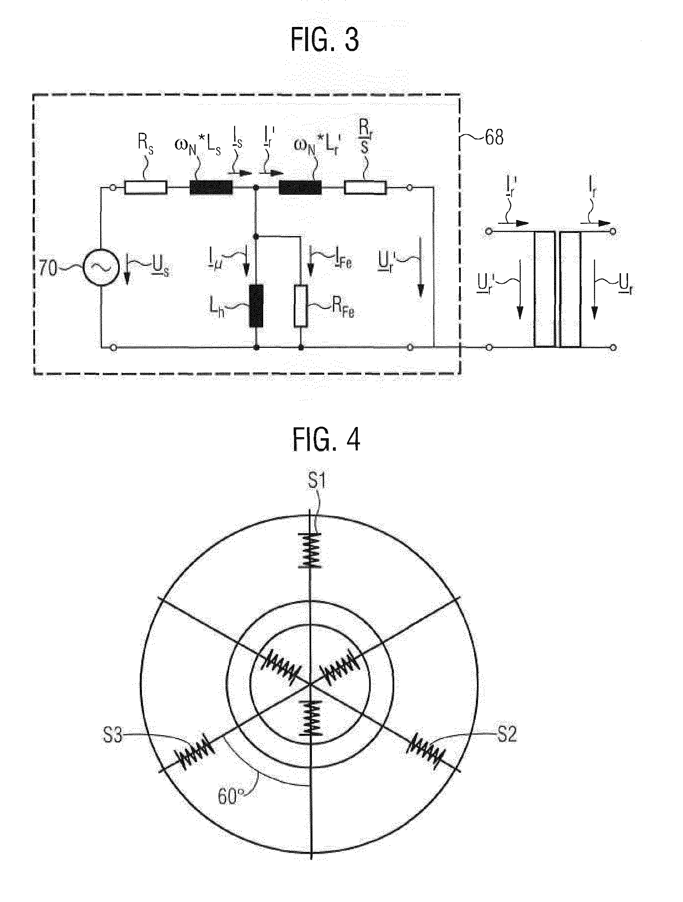

Ein einphasiges Ersatzschaltbild 68 eines Asynchronmotors mit einem Käfigläufer ist in FIG. 3 dargestellt. Dieses Ersatzschaltbild bildet einen Statorstrang der insgesamt drei Statoren des Asynchronmotors ab. Um dann ein Modell für den gesamten Motor mit drei Statorsträngen zu erhalten, können drei dieser Ersatzschaltbilder kombiniert werden. Dieses Vorgehen ist im vorliegenden Fall ausreichend, da, abgesehen von Phasenverschiebungen, die physikalischen Prozesse in den einzelnen Statorsträngen jeweils gleich sind. Dies trifft auch auf die physikalischen Prozesse in den Rotorzweigen zu. Zudem sind der magnetische Fluss und der elektrische Strom in jedem Statorstrang in Phase, so dass effektiv der magnetische Fluss nur von einer Phase erzeugt zu werden scheint, obwohl er von allen Phasen erzeugt wird.

Der Statorphase ist eine Versorgungsspannung $\underline{U}_s$ zugeordnet, welche von einer Spannungsversorgung 70 bereitgestellt wird. Die Kupfer- und Eisenverluste des Stators, die in Reihe geschaltet sind, werden durch den Statorwiderstand $R_s$, die des Rotors durch den Rotorwiderstand $R_r$ beschrieben. Aus der elektromagnetischen Induktion resultierende Streufelder werden durch Streuinduktivitäten beschrieben, für den Stator durch die Statorinduktivität $L_s$, und für den Rotor durch die Rotorinduktivität $L_r$. Jeder Rotorphase ist eine resultierende Rotorspannung $U_r$ zugeordnet. Durch den zeitlich veränderlichen magnetischen Fluss wird in dem Stator eine induzierte Statorspannung $U_{qs}$ und in dem Rotor eine induzierte Rotorspannung $U_{qr}$ erzeugt.

Der Spannungsabfall auf Seiten des Rotors hängt von der Versorgungsspannung $\underline{U}_s$ an der Statorseite und der Zahl der Windungen zwischen den Stator- und Rotorschaltkreisen ab. Der Transformationsfaktor r wird berechnet als der Quotient der Zahl der Statorwindungen $N_s$ und der Zahl der Rotorwindungen $N_r$:

$$r = \frac{N_s}{N_r}$$

Die Frequenz der Versorgungsspannung in den Statorwindungen wird im Folgenden mit $f_N$ bezeichnet, welche im vorliegenden Fall die Frequenz des Versorgungsnetzes von 50 Hz ist. Die Frequenz aller physikalischen Prozesse auf Seiten des Rotors ergibt sich aus der Differenz zwischen der Rotationsgeschwindigkeit des Rotors und der Rotationsgeschwindigkeit des magnetischen Feldes des Stators. Diese Frequenz ist stets um den Faktor s, welcher den elektrischen Schlupf bezeichnet, geringer als die Frequenz des Stators. Es gilt:

$$\frac{n_0}{f_N} = \frac{n_0 - n_M}{f_r} \quad \rightarrow \quad f_r = \frac{n_0 - n_M}{n_0} * f_N$$

$$s = \frac{n_0 - n_M}{n_0} \quad \rightarrow \quad f_r = s * f_N$$

Dabei ist $f_r$ die Frequenz von Rotorstrom bzw. Rotorspannung in der Einheit Hertz (Hz),
$n_0$ die Rotationsgeschwindigkeit des magnetischen Feldes Stators (= 3000 min$^{-1}$ bei 50 Hz) in der Einheit min$^{-1}$, und $n_M$ die Rotationsgeschwindigkeit des Rotors in der Einheit min$^{-1}$.
Mithilfe der komplexen Wechselstromrechnung kann aus dem Ersatzschaltbild folgende Gleichung für die Rotorseite abgeleitet werden:

$$\underline{U}_{qr} = R_r * \underline{I}_r + j * \omega_r * L_r * \underline{I}_r \quad \Leftrightarrow \quad \underline{U}_{qr} = R_r * \underline{I}_r + j * s * \omega_N * L_r * \underline{I}_r$$

wobei $\underline{I}_r$ der Rotorstrom ist,
$R_r * \underline{I}_r$ den Spannungsabfall am ohmschen Widerstand der Rotorphase in Volt bezeichnet,
$\omega_N$ die elektrische Winkelgeschwindigkeit, resultierend aus der Frequenf $f_N$ der Versorgungsspannung $\omega_N = 2\pi f_N [rad/s]$,
$\omega_r$ die elektrische Winkelgeschwindigkeit des Rotors, resultierend aus der Frequenz $f_r$ der vom Stator in den Rotor induzierten Spannung $\omega_r = 2\pi f_r [rad/s]$, und $s*\omega_N*L_r*I_r$ den Spannungsabfall an der Rotorspule in Volt bezeichnet.
Dabei werden ab hier die realen physikalische Grundsätze vernachlässigt, indem die Rotorfrequenz aus der Rechnung ausfaktoriert wird. Die Spannung wird durch den Schlupf s geteilt, wodurch die resultierende Gleichung einen Schaltkreis beschreibt, in dem die Spannung formal die Frequenz des Versorgungsnetzes hat und die Widerstände von der Rotationsgeschwindigkeit des Rotors abhängig werden. Das daraus resultierende System kann nun als Transformator behandelt werden, bei dem der Stator die Primärseite und der Rotor die Sekundärseite darstellen. Die induzierte Spannung im Rotor kann dann durch folgende Gleichung beschrieben werden:

$$\underline{U}'_{qr} = \frac{\underline{U}_{qr}}{s} = \frac{R_r}{s} * \underline{I}_r + j * \omega_N * L_r * \underline{I}_r$$

Wie bei einem Transformator entspricht das Verhältnis der Spannungen dem Transformationsfaktor r und das Verhältnis der entstehenden Ströme entspricht dem Inversen des Transformationsfaktors, d. h.:

$$U_s / U_r = \frac{N_s}{N_r} = r \,,$$

$$l_s / l_r = \frac{N_r}{N_s} = \frac{1}{r} \,.$$

Zur Vereinfachung der Rechnung werden der ohmsche Rotorwiderstand und seine Reaktanz, zusammengefasst in der Impedanz $\underline{Z}_r$, auf die Primärseite des Systems verschoben und müssen daher mit dem quadrierten Transformationsfaktor multipliziert werden:

$$\underline{Z}_r = \frac{\underline{U}_r}{\underline{I}_r} = \frac{\underline{U}_s}{r^2 * \underline{I}_s} = \frac{\underline{Z}'_r}{r^2}$$

$$\underline{Z}'_r = \underline{Z}_r * r^2$$

Hierbei ist $\underline{Z}_r$ die komplexe Impedanz, bestehend aus Widerstand und Reaktanz in $[\Omega]$,
$\underline{U}_r$ der Spannungsabfall an der Impedanz (Amplitude und Phase) in [V],
$\underline{I}_r$ der Strom durch die Impedanz (Amplitude und Phase) in [A],
$\underline{Z}'_r$ die komplexe Impedanz, auf die Primärseite des Systems transformiert, in $[\Omega]$.
Die magnetische Kopplung zwischen den Stator- und Rotorkreisen kann als parallele Reaktanz $L_h$ zwischen diesen beiden Kreisen beschrieben werden. Das auf diese Weise erhaltende Ersatzschaltbild umfasst nur Spulen und Widerstände.
Um nun den tatsächlichen Spannungsabfall an den offenen Enden der Rotorleiter und den resultierenden Strom bei deren Kurzschluss zu berechnen, müssen die Spannung $\underline{U}'_r$ und der Strom $\underline{I}'_r$ mit Hilfe des Transformationsfaktors r konvertiert werden:

$$\frac{U'_r}{U_r} = \frac{N_s}{N_r} \quad \leftrightarrow \quad U_r = U'_r * N_r / N_s$$

$$\frac{I'_r}{I_r} = N_r / N_s \quad \leftrightarrow \quad I_r = I'_r * N_s / N_r$$

Um die Eisenverluste resultierend aus der Ummagnetisierung des Eisenkerne zu berücksichtigen, wird ein Widerstand $R_{fe}$ parallel zu der Hauptinduktivität $L_h$ geschaltet.
Mit Hilfe dieses Ersatzschaltbildes können auf bekannte Weise Ströme, Spannungen und Leistungen (mit Ausnahme von Reibungsverlusten) des Asynchronmotors im Leerlauf und unter Last durch komplexe Wechselstromrechnung berechnet werden. Der Effektivwert des Rotorstroms kann berechnet werden, indem $I'_r$ mit dem Transformationsfaktor multipliziert wird.
Mit Ausnahme einer Phasenverschiebung von jeweils 120° sind die physikalischen Prozesse in den drei Stator- und Rotorzweigen im Normalfall im Wesentlichen die gleichen. Dennoch müssen bei der Erweiterung des Ersatzschaltbildes auf jeweils drei Zweige bzw. Phasen Einflüsse der einzelnen Zweige aufeinander berücksichtigt werden. So verursachen beispielsweise magnetische Felder, die von einer Windung erzeugt werden Ströme in anderen Leitern (Gegeninduktion). Ströme, die von magnetischen Feldern von benachbarten Zweigen erzeugt werden, müssen zu dem Strom, der aus dem Spannungsabfall an den Impedanzen in einem speziellen Zweig entsteht, addiert werden.
Bei Erweiterung des Ersatzschaltbildes auf drei Phasen müssen die Quellen des magnetischen Feldes - die Stator- und die Rotorwindungen - jeweils separat betrachtet werden. Während die Statorstränge eine feste räumliche Anordnung mit jeweils 120° Winkel zwischen den einzelnen Zweigen aufweisen, rotiert der Rotor mit einer bestimmten Rotationsgeschwindigkeit, woraus folgt, dass die Statorstränge zeitlich veränderliche Magnetfelder erfahren.

Grundsätzlich lassen sich zwei Typen von Induktionen unterscheiden: Die Selbstinduktion sowie die Gegeninduktion. Selbstinduktion beschreibt die Eigenschaft eines Leiters ein magnetisches Feld zu erzeugen, das Stromänderungen entgegenwirkt. Dies führt zu Spannungsabfällen an den entsprechenden Leitern. Gegeninduktion beschreibt den Einfluss, den magnetische Felder auf benachbarte Stromkreise haben. Beide Induktionen können berechnet werden, indem die Induktivität mit der Stromänderung (= Ableitung des Stromes nach der Zeit, di über dt) multipliziert wird:

$$u_q = L * \frac{di}{dt}$$

Dabei ist $u_q$ die induzierte Spannung in [V],
L die Induktivität, die das Magnetfeld erzeugt in [H] und
i der zeitlich veränderliche Strom, der durch die Induktivität L fließt in [A].

Der magnetische Fluss, der die Nachbarstränge beeinflusst, wird per Definition nur von der Hauptinduktivität $L_h$ erzeugt und die resultierende Spannung ist der selbstinduzierten Spannung entgegengesetzt. Der magnetische Fluss einer Phase, der die Nachbarphasen beeinflusst, kann anschließend mithilfe des Kosinus des Raumwinkels bzw. Zwischenwinkels zwischen den Phasen bestimmt werden, siehe dazu Fig. 4, in der drei Statorstränge s1, s2, s3 dargestellt sind, zwischen denen jeweils ein Winkel von 60° liegt.

Die in einen Statorstrang induzierte Spannung besteht aus

- Der selbstinduzierten Spannung erzeugt von den Induktivitäten $L_s$ und $L_h$
- Der Gegeninduktion von den beiden benachbarten Statorsträngen unter Berücksichtigung des Raumwinkels von 120° (= $\Pi/3$)
- Der Gegeninduktion von den Rotorsträngen unter Berücksichtigung des sich aufgrund der Rotation ändernden Raumwinkels $\alpha$

Wird Strang 1 als Bezugspunkt (Raumwinkel = 0°) angenommen, ergibt sich damit die von diesem Strang erzeugte Selbstinduktivität $u_{LS1}$ als

$$u_{Ls1} = (L_{h1} + L_{s1}) * \frac{di_{s1}}{dt}$$

Dabei ist $L_{h1}$ die Hauptinduktivität des Statorstrang 1,
$L_{s1}$ die Streuinduktivität des Statorstrang 1 und
$i_{s1}$ der in Statorstrang 1 fließende Strom.

Aus der Anordnung in Fig. 4 ergibt sich ein Winkel von 60° bzw. -60° zu den benachbarten Statorsträngen. Die von diesen Strängen erzeugte gegeninduzierte Spannung lässt sich wie oben beschrieben berechnen als:

$$u_{Ls2} = -\cos\left(\frac{\pi}{3}\right) \cdot L_{h2} \cdot \frac{di_{s2}}{dt} = -\frac{1}{2} \cdot L_{h2} \cdot \frac{di_{s2}}{dt}$$

$$u_{Ls3} = -\cos\left(-\frac{\pi}{3}\right) \cdot L_{h3} \cdot \frac{di_{s3}}{dt} = -\frac{1}{2} \cdot L_{h3} \cdot \frac{di_{s3}}{dt}$$

Dabei sind $u_{Ls2}$ und $u_{Ls3}$ die von Statorstrang 2 bzw. 3 induzierten Spannungen, $L_{h1}$ und $L_{h2}$ die Hauptinduktivitäten der Statorstränge 2 und 3 und $i_{s1}$ und $i_{s2}$ der in Statorstrang 1 und 2 fließende Wechselstrom

Da der Rotor sich innerhalb des Stators dreht, haben die einzelnen Rotorströnge keine festen Winkel bezogen auf die Statorstränge. Der Rotorwinkel ändert sich mit der Winkelgeschwindigkeit $\omega_M$ des Rotors. Zusätzlich muss der Winkel von 120° berücksichtig werden. Daraus ergibt sich für die vom Rotor induzierten Spannungen:

$$u_{Lr1} = \cos(\alpha) \cdot L_{h1} \cdot \frac{di_{r1}}{dt}$$

$$u_{Lr2} = \cos\left(\alpha + \frac{2\pi}{3}\right) \cdot L_{h2} \cdot \frac{di_{r2}}{dt}$$

$$u_{Lr3} = \cos\left(\alpha - \frac{2\pi}{3}\right) \cdot L_{h3} \cdot \frac{di_{r3}}{dt}$$

Dabei sind $u_{Lr1}$, $u_{Lr2}$ und $u_{Lr3}$ die vom Rotor induzierten Spannungen in [V],
$L_{h1}$, $L_{h2}$ und $L_{h3}$ die Hauptinduktivitäten in den drei Rotorsträngen in [H],
$i_{r1}$, $i_{r2}$ und $i_{r3}$ die Wechselströme in den drei Rotorsträngen in [A] und $\alpha$ der sich mit $\omega_M$ zeitlich veränderliche effektive Winkel des Rotors innerhalb der Statorwindungen

Um die Gesamtspannung in einem Statorstrang zu berechnen müssen die einzelnen Spannungen nun noch addiert werden:

$$u_{s1} = u_{Rs1} + u_{Ls1} + u_{Ls2} + u_{Ls3} + u_{Lr1} + u_{Lr2} + u_{Lr3}$$

$$\Leftrightarrow \qquad u_{s1} = R_{s1} \cdot i_{s1} + L_s \cdot \frac{di_s}{dt} + L_r \cdot \frac{di_r}{dt}$$

Wobei gilt:

$$L_s = \left[ L_{h1} + L_{s1} \quad -\frac{1}{2}L_{h2} \quad -\frac{1}{2}L_{h3} \right]$$

$$L_r = \left[ L_{h1} \cdot \cos(\alpha) \quad L_{h2} \cdot \cos\left(\alpha + \frac{2\pi}{3}\right) \quad L_{h3} \cdot \cos\left(\alpha - \frac{2\pi}{3}\right) \right]$$

$$i_s = \begin{bmatrix} i_{s1} & i_{s2} & i_{s3} \end{bmatrix}^T$$

$$i_r = \begin{bmatrix} i_{r1} & i_{r2} & i_{r3} \end{bmatrix}^T$$

Die Herleitung der Rotorgleichungen ist ähnlich der der Statorgleichungen, wobei aus Sicht des Rotors der Stator die sich bewegende Achse ist. Die resultierende Gleichung für Rotorstrang 1 ergibt sich demnach zu:

$$u_{r1} = u_{Rr1} + u_{Lr1} + u_{Lr2} + u_{Lr3} + u_{Ls1} + u_{Ls2} + u_{Ls3}$$

$$u_{r1} = R_{r1} \cdot i_{r1} + L_r \cdot \frac{di_r}{dt} + L_s \cdot \frac{di_s}{dt}$$

Wobei gilt:

$$L_r = \left[ L_{h1} + L_{r1} \quad -\frac{1}{2} L_{h2} \quad -\frac{1}{2} L_{h3} \right]$$

$$L_s = \left[ L_{h1} \cdot \cos(\alpha) \quad L_{h2} \cdot \cos\left(\alpha - \frac{2\pi}{3}\right) \quad L_{h3} \cdot \cos\left(\alpha + \frac{2\pi}{3}\right) \right]$$

$$i_r = \left[ i_{r1} \quad i_{r2} \quad i_{r3} \right]^T$$

$$i_s = \left[ i_{s1} \quad i_{s2} \quad i_{s3} \right]^T$$

Unter Berücksichtigung der Phasenverschiebung zwischen Rotor- und Statorsträngen kann nun das Gesamtsystem durch folgende Gleichung beschrieben werden:

$$\begin{bmatrix} u_s \\ u_r \end{bmatrix} = \begin{bmatrix} R_s & 0 \\ 0 & R_r \end{bmatrix} \cdot \begin{bmatrix} i_s \\ i_r \end{bmatrix} + \frac{d}{dt} \left( \begin{bmatrix} L_s & L_{sr}(\alpha) \\ L_{rs}(\alpha) & L_r \end{bmatrix} \cdot \begin{bmatrix} i_s \\ i_r \end{bmatrix} \right)$$

Und nach Umformung in den Zustandsraum:

$$\frac{d}{dt} \begin{bmatrix} i_s \\ i_r \end{bmatrix} = \begin{bmatrix} L_s & L_{sr}(\alpha) \\ L_{rs}(\alpha) & L_r \end{bmatrix}^{-1} \cdot \left( \begin{bmatrix} u_s \\ u_r \end{bmatrix} - \left( \begin{bmatrix} R_s & 0 \\ 0 & R_r \end{bmatrix} + \frac{d}{dt} \begin{bmatrix} L_s & L_{sr}(\alpha) \\ L_{rs}(\alpha) & L_r \end{bmatrix} \right) \cdot \begin{bmatrix} i_s \\ i_r \end{bmatrix} \right)$$

Mit $\dfrac{dL}{dt} = \omega_M \cdot \dfrac{dL}{d\alpha}$, wobei $\omega_M$ die Winkelgeschwindigkeit des Rotors ist, resultiert die Gleichung zu:

$$\frac{d}{dt} \begin{bmatrix} i_s \\ i_r \end{bmatrix} = \begin{bmatrix} L_s & L_{sr}(\alpha) \\ L_{rs}(\alpha) & L_r \end{bmatrix}^{-1} \cdot \left( \begin{bmatrix} u_s \\ u_r \end{bmatrix} - \left( \begin{bmatrix} R_s & 0 \\ 0 & R_r \end{bmatrix} + \omega_M \cdot \frac{d}{d\alpha} \begin{bmatrix} L_s & L_{sr}(\alpha) \\ L_{rs}(\alpha) & L_r \end{bmatrix} \right) \cdot \begin{bmatrix} i_s \\ i_r \end{bmatrix} \right),$$

wobei die verwendeten Matrizen wie folgt aufgebaut sind:
Statorstränge:

$$u_s = \begin{bmatrix} u_{s1} \\ u_{s2} \\ u_{s3} \end{bmatrix}, \; i_s = \begin{bmatrix} i_{s1} \\ i_{s2} \\ i_{s3} \end{bmatrix}, \qquad R_s = \begin{bmatrix} R_{s1} & 0 & 0 \\ 0 & R_{s2} & 0 \\ 0 & 0 & R_{s3} \end{bmatrix},$$

$$L_s = \begin{bmatrix} L_{h1} + L_{s1} & -\dfrac{L_{h2}}{2} & -\dfrac{L_{h3}}{2} \\[2ex] -\dfrac{L_{h1}}{2} & L_{h2} + L_{s2} & -\dfrac{L_{h3}}{2} \\[2ex] -\dfrac{L_{h1}}{2} & -\dfrac{L_{h2}}{2} & L_{h3} + L_{s3} \end{bmatrix}$$

Rotorstränge:

$$u_r = \begin{bmatrix} u_{r1} \\ u_{r2} \\ u_{r3} \end{bmatrix}, \; i_r = \begin{bmatrix} i_{r1} \\ i_{r2} \\ i_{r3} \end{bmatrix}, \; R_r = \begin{bmatrix} R_{r1} & 0 & 0 \\ 0 & R_{r2} & 0 \\ 0 & 0 & R_{r3} \end{bmatrix}, \; L_r = \begin{bmatrix} L_{h1} + L_{r1} & -\dfrac{L_{h2}}{2} & -\dfrac{L_{h3}}{2} \\[2ex] -\dfrac{L_{h1}}{2} & L_{h2} + L_{r2} & -\dfrac{L_{h3}}{2} \\[2ex] -\dfrac{L_{h1}}{2} & -\dfrac{L_{h2}}{2} & L_{h3} + L_{r3} \end{bmatrix}$$

Magnetische Kopplung zwischen Stator und Rotor:

$$L_{sr}(\alpha) = L_{rs}(\alpha)^T = \begin{bmatrix} L_{h1} \cdot \cos(\alpha) & L_{h2} \cdot \cos\left(\alpha + \dfrac{2\pi}{3}\right) & L_{h3} \cdot \cos\left(\alpha - \dfrac{2\pi}{3}\right) \\[2ex] L_{h1} \cdot \cos\left(\alpha - \dfrac{2\pi}{3}\right) & L_{h2} \cdot \cos(\alpha) & L_{h3} \cdot \cos\left(\alpha + \dfrac{2\pi}{3}\right) \\[2ex] L_{h1} \cdot \cos\left(\alpha + \dfrac{2\pi}{3}\right) & L_{h2} \cdot \cos\left(\alpha - \dfrac{2\pi}{3}\right) & L_{h3} \cdot \cos(\alpha) \end{bmatrix}$$

Das Gleichungssystem besteht nun aus 6 Differentialgleichungen und kann unter Zuhilfenahme der Drehmomentgleichungen um zwei weitere aufgestockt werden.

Das elektrische Drehmoment einer Asynchronmaschine kann mithilfe der Leistungsanalyse berechnet werden. Es ist das Produkt von Strom und Spannung jedes Stator- und Rotorstrangs:

$$\begin{bmatrix} P_s \\ P_r \end{bmatrix} = \begin{bmatrix} i_s \\ i_r \end{bmatrix}^T \cdot \begin{bmatrix} u_s \\ u_r \end{bmatrix}$$

Wobei gilt:

$P_s$ und $P_r$ sind die elektrischen Leistungen der Stator- und Rotostränge ($[P_{s1} \; P_{s2} \; P_{s3} \; P_{r1} \; P_{r2} \; P_{r3}]^T$)
$i_s$ und $i_r$ sind die Wechselströme in den Stator- und Rotorsträngen ($[I_{s1} \; i_{s2} \; i_{s3} \; i_{r1} \; i_{r2} \; i_{r3}]^T$)
$u_s$ und $u_r$ sind die Spannungsabfälle an Stator- und Rotorsträngen ($[u_{s1} \; u_{s2} \; u_{s3} \; u_{r1} \; u_{r2} \; u_{r3}]^T$)

Setzt man diese Gleichungen in das oben beschriebene Gleichungssystem ein, erhält man:

$$\begin{bmatrix} P_s \\ P_r \end{bmatrix} = \begin{bmatrix} i_s \\ i_r \end{bmatrix}^T \cdot \left( \begin{bmatrix} R_s & 0 \\ 0 & R_r \end{bmatrix} \cdot \begin{bmatrix} i_s \\ i_r \end{bmatrix} + \frac{d}{dt}\left( \begin{bmatrix} L_s & L_{sr}(\alpha) \\ L_{rs}(\alpha) & L_r \end{bmatrix} \cdot \begin{bmatrix} i_s \\ i_r \end{bmatrix} \right) \right)$$

Mithilfe der Produktregel kann die Gleichung umgeformt werden:

$$\begin{bmatrix} P_s \\ P_r \end{bmatrix} = \underbrace{\begin{bmatrix} i_s \\ i_r \end{bmatrix}^T \cdot \begin{bmatrix} R_s & 0 \\ 0 & R_r \end{bmatrix} \begin{bmatrix} i_s \\ i_r \end{bmatrix}}_{P_{cu}} + \underbrace{\begin{bmatrix} i_s \\ i_r \end{bmatrix}^T \cdot \begin{bmatrix} L_s & L_{sr}(\alpha) \\ L_{rs}(\alpha) & L_r \end{bmatrix} \cdot \frac{d}{dt} \begin{bmatrix} i_s \\ i_r \end{bmatrix}}_{E_c} + \underbrace{\begin{bmatrix} i_s \\ i_r \end{bmatrix}^T \cdot \frac{d}{dt} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix}}_{E_m}$$

wobei gilt:

- $P_{cu}$ bezeichnen die Kupferverluste des Systems
- $E_c$ sind die Veränderungen des magnetischen Feldes
- $E_m$ ist die magnetische Energie

Die Hälfte der magnetischen Energie wird in den Windungen gespeichert, die andere Hälfte wird in Bewegungsenergie umgewandelt. Die resultierende mechanische Leistung (bei Vernachlässigung von Reibungs- und Eisenverlusten) ergibt sich damit zu:

$$P_{mech} = \frac{1}{2} \cdot E_m = \frac{1}{2} \cdot \begin{bmatrix} i_s \\ i_r \end{bmatrix}^T \cdot \frac{d}{dt} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix}$$

Das elektrische Drehmoment ist definiert als der Quotient von mechanischer Leistung und Winkelgeschwindigkeit des Rotors:

$$M_{el} = \frac{P_{mech}}{\omega_M}$$

Einsetzen dessen in die Gleichung für mechanische Leistung führt zu:

$$M_{el} = \frac{P_{mech}}{\omega_M} = \frac{1}{2 \cdot \omega_M} \cdot \begin{bmatrix} i_s \\ i_r \end{bmatrix}^T \cdot \frac{d}{dt} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix}$$

Mit $\dfrac{d\alpha}{dt} = \omega_M$ wiederum:

$$M_{el} = \frac{1}{2} \cdot \begin{bmatrix} i_s \\ i_r \end{bmatrix}^T \cdot \frac{d}{d\alpha} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix}$$

Während des Betriebs ist die resultierende Winkelgeschwindigkeit die Differenz zwischen mechanischem Drehmoment und Lastmoment an der Rotorwelle unter Berücksichtigung der Massenträgheit des Motors:

$$J \cdot \frac{d\omega_M}{dt} = M_{el} - M_L$$

Wobei gilt:

- J ist die Massenträgheit des Motors

- $\omega_M$ ist die Winkelgeschwindigkeit des Rotors
- $M_{el}$ ist das elektrische Drehmoment
- $M_L$ ist das Lastmoment

Einsetzen dessen in die Gleichung für das elektrische Drehmoment führt zu:

$$J \cdot \frac{d\omega_M}{dt} = \frac{1}{2} \cdot \begin{bmatrix} i_s \\ i_r \end{bmatrix}^T \cdot \frac{d}{d\alpha} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix} - M.$$

Auflösen dieser Gleichung führt zu einer Gleichung zur Bestimmung der Winkelgeschwindigkeit des Rotors:

$$\frac{d\omega_M}{dt} = \frac{1}{2J} \cdot \left( \begin{bmatrix} i_s \\ i_r \end{bmatrix}^T \cdot \frac{d}{d\alpha} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix} - 2 \cdot M_L \right),$$

wobei die Änderung des Rotorwinkels $\alpha$ nach der Zeit die Winkelgeschwindigkeit ergibt:

$$\frac{d\alpha}{dt} = \omega_M$$

Insgesamt ergibt sich für das System demnach ein Gleichungssystem bestehend aus insgesamt 8 Gleichungen:

$$\begin{bmatrix} u_s \\ u_r \end{bmatrix} = \begin{bmatrix} R_s & 0 \\ 0 & R_r \end{bmatrix} \cdot \begin{bmatrix} i_s \\ i_r \end{bmatrix} + \frac{d}{dt} \left( \begin{bmatrix} L_s & L_{sr}(\alpha) \\ L_{rs}(\alpha) & L_r \end{bmatrix} \cdot \begin{bmatrix} i_s \\ i_r \end{bmatrix} \right)$$

$$\frac{d\omega_M}{dt} = \frac{1}{2J} \cdot \left( \begin{bmatrix} i_s \\ i_r \end{bmatrix}^T \cdot \frac{d}{d\alpha} \left( \begin{bmatrix} L_s & L_{sr}(\alpha) \\ L_{rs}(\alpha) & L_r \end{bmatrix} \right) \cdot \begin{bmatrix} i_s \\ i_r \end{bmatrix} - 2 \cdot M_L \right)$$

$$\frac{d\alpha}{dt} = \omega_M$$

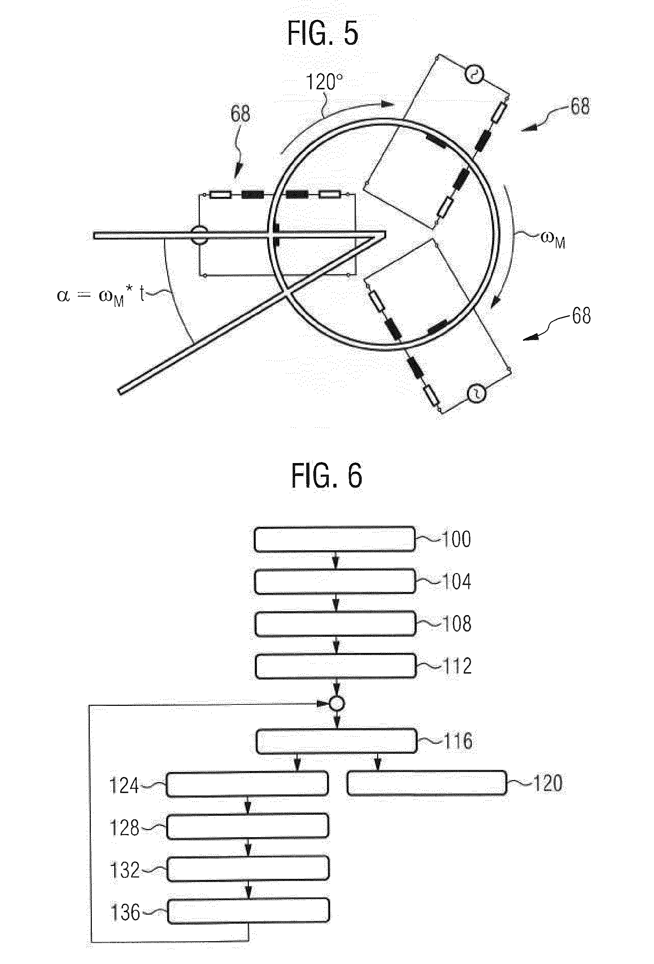

Durch das in Fig. 5 dargestellte dreiphasige Ersatzschaltbild werden nicht alle im Motor ablaufenden physikalischen Prozesse berücksichtigt. Dazu gehören:

- Magnetische Streufelder, welche von Streuinduktivitäten verursacht werden und gewissermaßen Verluste der Magnetkraft zwischen Stator und Rotor darstellen
- Eisenverluste, welche durch die Ummagnetisierung der Eisenkomponenten durch zeitlich veränderbare magnetische Felder entstehen und proportional zur Magnetfeldstärke und -frequenz sind
- Reibungsverluste aufgrund der mechanischen Lagerung des Rotors, welche mit steigender Rotationsfrequenz wachsen
- Skineffekte, welche durch die Änderungen der Stromdichte in einem elektrischen Leiter aufgrund eines rotierenden magnetischen Feldes hervorgerufen werden

Vom Modell berücksichtigt werden nur Kupferverluste, welche durch die intrinsischen Widerstände der verwendeten Kupferleiter zustande kommen.
Mithilfe des Gleichungssystems bestehend aus 8 Differentialgleichungen kann die Asynchronmaschine nun simuliert werden. Dazu werden die Parameter des Modells (Widerstände und Induktivitäten) auf konkrete Werte gesetzt, das Modell mit einer Eingangsspannung = Netzspannung gespeist und die resultierenden Größen (Ströme, Drehmoment, Rotorwinkels) berechnet. Die Ergebnisse des Modells können schließlich mit den realen Messwerten der Maschine verglichen werden.

Um eine Asynchronmaschine mithilfe des Modells überwachen zu können, muss das Modell zunächst so parametriert werden, dass die Ausgangsgrößen des Modells (Statorstrom und Rotationsgeschwindigkeit des Rotors) mit denen der an der realen Maschine messbaren Größen übereinstimmen. Da das Gleichungssystem mit 15 Parametern in 8 Differentialgleichungen unterbestimmt ist, müssen die Initialparameter möglichst ähnlich den tatsächlichen Parametern gewählt werden. Dazu werden die Werte des vom Hersteller der Maschine mitgelieferten einphasigen Ersatzschaltbildes herangezogen, wobei die Hauptinduktivitäten um 1/3 reduziert werden müssen um den dreiphasigen Aufbau zu berücksichtigen.

Die quadratische Standardabweisung der Messgrößen von den Modellausgangsgrößen kann beschrieben werden als:

$$g(c) = \frac{1}{N} \cdot \sum_{t=1}^{N} \left( y_m(t) - y_c(c,t) \right)^2 \,,$$

wobei gilt:

- N ist die Anzahl der diskreten Messwerte zu den Zeitpunkten t
- $y_m$ ist der Messwert zum Zeitpunkt t
- $y_c$ ist der berechnete Wert zum Zeitpunkt t
- c steht für alle Parameter des Systems

Ziel ist es nun, die quadratische Standardabweichung zu minimieren um die Parameter c zu bestimmen. Für die Asynchronmaschine sind diese Parameter c:

- die Statorwiderstände $R_{s1}$, $R_{s2}$, $R_{s3}$
- die Rotorwiderstände $R_{r1}$, $R_{r2}$, $R_{r3}$
- die Statorinduktivitäten $L_{s1}$, $L_{s2}$, $L_{s3}$
- die Rotorinduktivitäten $L_{r1}$, $L_{r2}$, $L_{r3}$
- die Kopplungsinduktivitäten $L_{h1}$, $L_{h2}$, $L_{h3}$

Um die Funktion g(c) zu minimieren wird das Verfahren des steilsten Abstiegs verwendet. Hierzu wird zunächst der Gradient $\nabla g(c)$ als Ableitung der Funktion g(c) in alle 15 Parameterrichtungen benötigt:

$$\nabla g(c) = -\frac{2}{N} \cdot \sum_{t=1}^{N} \left( y_m(t) - y_c(c,t) \right) \cdot \frac{\partial y_c(c,t)}{\partial c}$$

wobei gilt:

- N ist die Anzahl der diskreten Messwerte zu den Zeitpunkten t
- c steht für alle Parameter des Systems
- $y_m(t)$ ist der Messwert zum Zeitpunkt t
- $y_c(c,t)$ ist der berechnete Wert zum Zeitpunkt t mithilfe gegebener Parameter c
- $\partial y_c(c,t)/\partial c$ ist die partielle Ableitung von $y_c(c,t)$ in Richtung c

Zur Bestimmung des Gradienten werden demnach die partiellen Ableitungen aller 8 Modellgleichungen in alle 15 Parameterrichtungen benötigt. Diese lassen sich mithilfe der höheren Mathematik nach bekanntem Verfahren bestimmen.

Ein Ablaufdiagramm eines Optimierungsprozesses, der Teil des Verfahrens ist, ist in FIG. 6 dargestellt. In Block 100 werden die Anfangswerte aller Modellparameter gewählt. Diese Werte stellen die Ausgangswerte für die Parameter des Differentialgleichungssystems dar. In Block 104 wird im Anschluss die Größe g(c) berechnet, welche die quadratische Standardabweichung zwischen einer gemessenen und einer berechneten Serie von Ausgangsgrößen darstellt. In Block 108 wird dann der Gradient $\nabla g(c)$ der Größe g(c) berechnet. Das Ergebnis dieser Operation ist ein ein 15-dimensionaler Vektor im Raum der Maschinenparameter, welcher senkrecht auf den Äquipotentialflächen steht und in diesem Raum in Richtung der größten Änderung zeigt. In Block 112 wird die Norm des Gradienten berechnet, die es ermöglicht, ein geeignetes Abbruchkriterium für die Parameteroptimierung zu formulieren. Die Optimierung wird abgebrochen, wenn die Norm des Gradienten unter einen vorgegebenen Schwellenwert sinkt (in diesem Fall ist die Abweichung zwischen Messgrößen und Modellparameter hinreichend klein). Je kleiner die Norm des Gradienten ist, umso kleiner die größte Steigung, d. h., im multidimensionalen Parameterraum wird mit kleiner werdendem Gradient der Abstieg (im Falle einer Minimierung) immer flacher, was im Regelfall darauf hindeutet, dass der optimale Wert bzw. zumindest ein lokales Optimum schon relativ gut erreicht wurde.

In Block 116 wird überprüft, ob die Gradientennorm größer als ein vorgegebener Schwellenwert ist. Ist dies nicht der Fall, wird die Minimierung in Block 120 beendet. Andernfalls wird die Minimierung in Block 124 gestartet bzw. in Form einer Schleife, welche die Blöcke 124, 128, 132, 136 und 116 umfasst, weitergeführt. In Block 124 werden mit Hilfe des Gradienten die neuen Werte der Modellparameter berechnet (nach dem Verfahren des steilsten Abstiegs). Die Schrittweite in Richtung der einzelnen Gradientenrichtungen wird dabei mithilfe der Armijo-Goldstein-Regel bestimmt, wodurch sichergestellt wird, dass eine Verkleinerung von g(c) erreicht wird.

Im Anschluss werden in Block 128 die neuen Parameter gespeichert. In Block 132 wird wieder der Gradient berechnet, und in Block 136 wird seine Norm berechnet. Das Verfahren wird dann bei Block 116 fortgesetzt, in welchem das Abbruchkriterium erneut überprüft wird. Falls es erfüllt ist, endet der Optimierungsprozess in Block 120. Das Ergebnis der Optimierung ist dann ein neuer Satz von Maschinenparametern, mit welchen die Lösung des Differentialgleichungssystems eine verbesserte Näherung an die gemessenen Ausgangsgrößen darstellt.

Als Abbruchkriterium für das Optimierungsverfahren kann gewählt werden:

- Die Gradientennorm fällt unter einen vorgegebenen Schwellenwert
- Eine vorgegebene maximale Anzahl von Iterationsschritten ist erreicht
- Die aktuelle Schrittweite fällt unter einen vorgegebenen Schwellenwert

Da das Differentialgleichungssystem mit 8 Gleichungen und 15 Parametern unterbestimmt ist, ist das Ergebnis der Optimierung stark von den anfänglichen Werten der Parameter abhängig. Die Initialwerte des Modells können aus den Herstellerunterlagen entnommen werden und die Maschine muss kontinuierlich überwacht werden, um Änderungen in den Parametern frühzeitig erkennen und das Modell dahingehend anpassen zu können.

In Fällen, in denen die Art der Störung vermutet wird und damit auch eine Vermutung über die damit zusammenhängenden Parameter vorliegt, kann eine Auswahl aller Parameter optimiert werden. Ebenso kann die Geschwindigkeit des Optimierungsprozesses dadurch erhöht werden, dass zur Berechnung von g(c) nur eine begrenzte Auswahl der verfügbaren Messpunkte berücksichtigt wird.

Ein beispielhafter Motor, bei dem mit dem geschilderten Verfahren eine Fehlerdiagnose durchgeführt werden kann, hat folgende Kenngrößen:

| | |
|---|---|
| Nennspannung: | 400 V, 50 Hz |
| Nennstrom: | 4,5 A |
| Nenndrehmoment: | 7,4 Nm |
| Nennleistung: | 2,2 kW |
| Maximales Drehmoment: | 16 Nm |

Die Parameter eines dazu gehörigen Ersatzschaltbildes sind:

| | |
|---|---|
| $R_s$ (Statorwiderstand): | 2,41-3,37 $\Omega$ |
| $R_r$ (Rotorwiderstand): | 2,96 $\Omega$ |
| $L_h$ (Hauptkopplungsinduktivität): | 0,314 H |
| $L_s$ (Streuinduktivität des Stators): | 0,108 H |
| $L_r$ (Streuinduktivität des Rotors): | 0,00924 H |

Die Eingangsgrößen des Motors sind die Nennspannung und -frequenz. Die Ausgangsgrößen, die gemessen werden und mit Hilfe derer die Optimierung durchgeführt wird, sind Statorstrom und Rotordrehzahl.

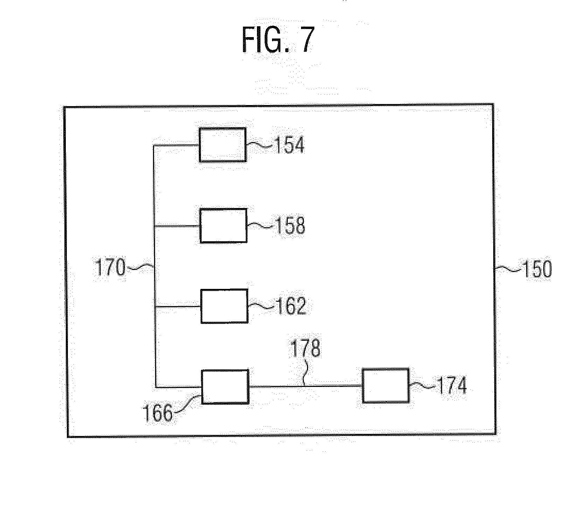

In Fig. 7 ist eine Vorrichtung 150 zur Ausführung eines oben dargestellten Verfahrens in einer bevorzugten Ausführungsform dargestellt. Die Vorrichtung 150 umfasst ein Initialabgleichsmodul 154, in welchem der initiale Abgleich zwischen den Eingangsgrößen der Maschine und den korrespondierenden Eingangsgrößen des Modells durchgeführt wird. In einem Überwachungsmodul 158 wird die Maschine zu vorgegebenen Zeitpunkten oder auch kontinuierlich

anhand der Ausgangsgrößen überwacht, wobei überprüft wird, ob diese von einem Normalfall, der einem fehlerlosen Betrieb der Maschine entspricht, abweichen. Ist dies der Fall, wird in einem Optimierungsmodul 162 eine Optimierung der Modellparameter dahingehend durchgeführt, dass die Ausgangsgrößen der Maschine mit denen des Modells in Übereinstimmung bzw. bestmöglichsts in Übereinstimmung gebracht werden, was beispielsweise durch die Minimierung der Summe ihrer quadratischen Abweichungen erreicht werden kann ($X^2$-Fit).

In einem Diagnosemodul 166 wird nun aufgrund des von dem Optimierungsmodul 162 bestimmten neuen Satzes an Modellparametern eine Fehlerdiagnose durchgeführt. Die Module 154, 158, 162 und 166 sind über eine Datenverbindung 170 miteinander verbunden und können miteinander kommunizieren. Sie können als Softwaremodule auf einer gemeinsamen Hardware-Architektur realisiert sein oder auch als getrennte Hardware-Module, die beispielsweise über einen gemeinsamen Bus miteinander kommunizieren.

Die Vorrichtung 150 umfasst weiterhin eine Datenbank 174, welche über eine Datenverbindung 178 mit dem Diagnosemodul 166 verbunden ist. In der Datenbank 174 ist eine Mehrzahl von Schadensszenarien abgelegt, welche jeweils Abweichungen der Modellparameter von ihren normalen Werten, die einer intakten Maschine entsprechen, zugeordnet sind. Das Diagnosemodul 174 kann daher die Datenbank abfragen, ob ein vorliegendes Schadensszenario bereits bekannt ist, wodurch die Diagnose der Maschine und eine entsprechende Meldung sehr effektiv und schnell möglich durchgeführt werden können.

Bezugszeichenliste

| | |
|---|---|
| 2 | Block |
| 6 | Pfeil |
| 10 | Block |
| 14 | Pfeil |
| 18 | Pfeil |
| 22 | Block |
| 26 | Block |
| 30 | Block |
| 34 | Doppelpfeil |
| 40 | Block |
| 44 | Block |
| 48 | Block |
| 52 | Block |
| 56 | Block |
| 68 | Ersatzschaltbild |
| 70 | Spannungsversorgung |
| 100 | Block |
| 104 | Block |
| 108 | Block |
| 112 | Block |
| 116 | Block |
| 120 | Block |
| 124 | Block |
| 128 | Block |
| 132 | Block |
| 136 | Block |
| 150 | Vorrichtung |
| 154 | Initialabgleichsmodul |
| 158 | Überwachungsmodul |
| 162 | Optimierungsmodul |
| 166 | Diagnosemodul |
| 170 | Datenverbindung |
| 174 | Datenbank |
| 178 | Datenverbindung |
| $U_s$ | Versorgungsspannung |
| $R_s$ | Statorwiderstand |

$R_r$     Rotorwiderstand
$L_s$     Statorinduktivität
$L_r$     Rotorinduktivität
$U_{qs}$     induzierte Statorspannung
$U_{qr}$     induzierte Rotorspannung
$r$     Transformationsfaktor
$N_s$     Zahl der Statorwindungen
$N_r$     Zahl der Rotorwindungen
$f_N$     Frequenz der Versorgungsspannung
$w_M$     Rotationsgeschwindigkeit
$\alpha$     effektiver Winkel
s1     Statorstrang
s2     Statorstrang
s3     Statorstrang

## Patentansprüche

1. Verfahren zur Erkennung von Fehlern einer elektrischen Maschine, welcher Eingangsgrößen, Ausgangsgrößen und Maschinenparameter zugeordnet sind, **dadurch gekennzeichnet, dass**
die Maschine auf ein mathematisches Modell abgebildet wird,
wobei

     • das Modell Eingangsgrößen aufweist und Modellparameter, welche jeweils Modellfunktionen von den Maschinenparametern sind,
     • vor Betriebsbeginn der Maschine ein Initialabgleich der Eingangsgrößen zwischen Maschine und Modell durchgeführt wird,
     • die Maschine während des Betriebs zu vorgegeben Zeitpunkten oder im Wesentlichen kontinuierlich anhand der Ausgangsgrößen überwacht wird,
     • bei Abweichen der Ausgangsgrößen vom Normalfall durch einen Optimierungsprozess die Modellparameter derart bestimmt werden, dass die Ausgangsgrößen des Modells mit denen der Maschine übereinstimmen,
     • und aufgrund der daraus bestimmten Modellparameter eine Fehlerdiagnose durchgeführt wird.

2. Verfahren nach Anspruch 1, wobei für wenigstens eine Modellfunktion die Einheitsfunktion gewählt wird.

3. Verfahren nach Anspruch 1 oder 2, wobei die Maschine ein Asynchronmotor mit einem Käfigläufer ist.

4. Verfahren nach Anspruch 3, wobei die Eingangsgrößen ein oder mehrere Elemente umfassen der Gruppe: sinusförmige Dreiphasen-Wechselspannung, Einphasen-Wechselspannung, Gleichstrom.

5. Verfahren nach Anspruch 3 oder 4, wobei die Ausgangsgrößen ein oder mehrere Elemente umfassen der Gruppe: Statorstrom, Statorspannung, Rotordrehzahl, elektrisches Drehmoment, mechanisches Drehmoment.

6. Verfahren nach einem der Ansprüche 3 bis 5, wobei das Modell zeitabhängig ist und ein elektrisches Ersatzschaltbild des Asynchronmotors umfasst.

7. Verfahren nach einem der Ansprüche 1 bis 6, wobei für den Optimierungsprozess ein Gradientenschrittverfahren eingesetzt wird.

8. Verfahren nach einem der Ansprüche 1 bis 7, wobei zur Optimierung die Summe von quadratischen Abweichungen der Ausgangsgrößen des Modells von denen der Maschine minimiert wird.

9. Vorrichtung (150) mit Mitteln (154, 158, 162, 166) zur Durchführung eines Verfahrens nach einem der vorherigen Ansprüche.

10. Vorrichtung (150) nach Anspruch 9 mit einer Datenbank (174), in der Abweichungen der Modellparameter von Normalwerten jeweils ein oder mehrere Schadensszenarien zugeordnet werden.

## FIG. 1

## FIG. 2

# FIG. 3

# FIG. 4

## FIG. 5

$\alpha = \omega_M {}^* t$

$120°$

$68$

$68$

$68$

$\omega_M$

## FIG. 6

100

104

108

112

116

124

128

132

136

120

# FIG. 7